# EUROPEAN PATENT APPLICATION

(11) **EP 4 746 606 A1**
(43) Date of publication of application: **20.05.2026**
(21) Application number: 25215847.2
(22) Date of filing: 14.11.2025
(51) Int. Cl.: H05K 7/14, G11B 33/08

(54) **A VIBRATION ISOLATION SYSTEM**

(30) Priority: 15.11.2024 IN 202421088512
(71) Applicant: Vertiv Corporation, Westerville, OH 43082 (US)
(72) Inventor: PATIL, Shridhar Jaywant, Westerville, 43082 (US)
(74) Representative: Ambroz, Simon

(57) **Abstract**

The present invention relates a vibration isolation system (100) for isolating vibrations from transmitting to a cabinet (10). The system (100) comprises a bottom frame (18) configured to be mounted on a rigid surface (24), said bottom frame (18) having a bottom surface (20) and side surfaces (22) extending vertically therefrom. A top frame (12) is configured to support the cabinet (10). The top frame (12) is movably mounted on the bottom frame (18). A plurality of primary resilient members (30) is positioned between ledges (16) of the top frame (12) and the side surfaces (22) of the bottom frame (18). A plurality of secondary resilient members (32) are positioned between an operating surface of a mounting base (15) of said top frame (12) and said bottom surface (20) of said bottom frame (18).

## Description

The present disclosure relates to vibration isolation systems. More specifically, the present disclosure concerns a vibration isolation mechanism designed to mitigate the effects of seismic and other vibrational forces on mounted structures.

### BACKGROUND

The background information herein below relates to the present disclosure but is not necessarily prior art.

Typically, cabinets are employed to house and secure various types of electrical equipment and machinery. These pieces of equipment and machines are electrically and functionally interconnected through one or more cables and adapters. In conventional configuration, the cabinets are usually floor-mounted on a plinth, which serves as a supportive base and creates space for routing cables and wiring underneath. To ensure optimal equipment performance, cabinet stability is essential. However, during events such as seismic activity, heavy construction, or demolition, substantial vibrations are produced. Since these conventional cabinets are mounted directly on the ground, so during these critical events, vibrations transfer directly to the cabinet, causing unwanted movement. This unwanted movement disrupts both the equipment and the electrical connections, potentially resulting in damage or equipment failure.

Further, the conventional plinth configuration generally relies on rigid connections and reinforcements to withstand seismic forces. Although this configuration may provide a certain degree of stability, it often requires significant material use, raising the overall production cost of the cabinet.

Therefore, there is a need for a vibration isolation system for cabinets and enclosures that alleviates the aforementioned drawbacks.

### SUMMARY OF THE INVENTION

This summary is provided to introduce aspects related to a vibration isolation system and the aspects are further described below in the detailed description. This summary is not intended to identify essential features of the claimed subject matter nor is it intended for use in determining or limiting the scope of the claimed subject matter.

The present invention relates to a vibration isolation system for isolating vibrations from transmitting to a cabinet. The system comprises a bottom frame configured to be mounted on a rigid surface. The bottom frame having a bottom surface and side surfaces extending vertically therefrom. A top frame is configured to support the cabinet. The top frame comprises a mounting base and ledges extending outwardly from the mounting base. The top frame is movably mounted on the bottom frame. A plurality of primary resilient members is positioned between the ledges of said top frame and said side surfaces of the bottom frame. The primary resilient members are configured to restrict lateral movement of said top frame within said bottom frame. A plurality of secondary resilient members is positioned between an operating surface of said mounting base of said top frame and said bottom surface of said bottom frame. The secondary resilient members are configured to restrict vertical movement of said top frame relative to said bottom frame. The primary resilient members and the secondary resilient members are collectively configured to absorb vibrational forces in both lateral and vertical directions, thereby isolating the cabinet from external vibrations transmitted through said bottom frame.

In one aspect, the bottom frame is a box-shaped structure comprising a C-shaped pocket and an opening. The opening is configured to receive said top frame such that said ledges of said top frame are positioned within said pocket.

In one aspect, the primary resilient members are arranged in a spaced manner along the inner surfaces of said side surfaces of said bottom frame. Each of said primary resilient members having one end coupled to said ledges and an opposite end abutting the inner surface of said side surfaces of said bottom frame.

In one aspect, the secondary resilient members are arranged in a grid pattern on said bottom surface of said bottom frame. Each of said secondary resilient members have one end coupled to the operative surface of said mounting base of said top frame and an opposite end abutting the bottom surface of said bottom frame.

In one aspect, the bottom frame includes a plurality of fasteners configured to secure said bottom frame to the rigid surface. The fasteners are capable of withstanding oscillating forces acting on said bottom frame.

In one aspect, each of said primary resilient members and each of said secondary resilient members has stiffness level, configured to collectively absorb vibrations in multi-directional axes without compromising the stability of said top frame and the cabinet.

In one aspect, the top frame is dimensioned to allow lateral displacement within a predefined tolerance range inside the bottom frame, to provide controlled flexibility to absorb lateral and vertical vibrations.

In one example, a method for isolating vibrations from transmitting to a cabinet mounted on a vibration isolation system is described. The method includes providing a bottom frame and mounting said bottom frame on a rigid surface. The bottom frame has a bottom surface and side surfaces extend vertically therefrom. The method further includes positioning a top frame within said bottom frame. The top frame comprises a mounting base and ledges extending outwardly from the mounting base. The method further includes mounting a plurality of primary resilient members between said ledges of said top frame and said side surfaces of said bottom frame. The primary resilient members restrict lateral movement of said top frame relative to said bottom frame. The method further includes mounting a plurality of secondary resilient members between said mounting base of said top frame and said bottom surface of said bottom frame. The said secondary resilient members restrict vertical movement of the top frame relative to the bottom frame. The method further includes securing the cabinet on said mounting base of said top frame. The method further includes absorbing vibrations through said primary resilient members and said secondary resilient members. The primary resilient members absorb lateral vibrations and said secondary resilient members absorb vertical vibrations, thereby isolating the cabinet from external vibrations.

In one aspect, the method further includes securing said bottom frame to the rigid surface using a plurality of fasteners capable of withstanding oscillating forces.

In one aspect, the method further comprises providing the bottom frame includes forming said bottom frame as a box-shaped structure with a C-shaped pocket to receive said top frame. Positioning said top frame within said bottom frame includes inserting the ledges of said top frame within said C-shaped pocket.

In one aspect, mounting said primary resilient members includes arranging said primary resilient members in a spaced manner along the inner surfaces of said side surfaces of said bottom frame. Each of said primary resilient member having one end coupled to said ledges and an opposite end abutting said side surfaces of said bottom frame.

In one aspect, mounting said secondary resilient members includes arranging said secondary resilient members in a grid pattern on said bottom surface of said bottom frame. Each of said secondary resilient members has one end coupled to said mounting base of said top frame and an opposite end abutting said bottom surface of said bottom frame.

In one aspect, the method further includes providing a tolerance between said ledges and said side surfaces of said bottom frame.

In one aspect, the method further includes selecting the stiffness levels of said primary resilient members and said secondary resilient members, enabling said resilient members to dampen multi-directional vibrations.

### BRIEF DESCRIPTION OF THE DRAWINGS

The accompanying figures of the drawing, which are included to provide a further understanding of general aspects of the system/method, are incorporated in and constitute a part of this specification. These illustrative aspects of the system/method, and together with the detailed description, explain the principles of the system. No attempt is made to show structural details in more detail than is necessary for a fundamental understanding of the system and various ways in which it is practiced. The following figures of the drawing include:
**FIG. 1** illustrates the vibration isolation system for a cabinet, in accordance with the present disclosure;
**FIG. 2** illustrates a sectional front view of the vibration isolation system of **FIG.** 1, in accordance with the present disclosure;
**FIG. 3** illustrates a top view of the vibration isolation system of **FIG.** 1, in accordance with the present disclosure;
**FIG. 4** illustrates an exploded view of the vibration isolation system of **FIG.** 1, in accordance with the present disclosure;
**FIG. 5** illustrates the isometric view of the bottom frame, in accordance with the present disclosure;
**FIG. 6** illustrates the displacement of the vibration isolation system along sideways (X-axis) direction loading to mitigate the transmission of vibration, in accordance with one example of the present disclosure;
**FIG. 7** illustrates the displacement of the vibration isolation system in front-to-back (Z-axis) direction loading to mitigate the transmission of vibration, in accordance with one example of the present disclosure; and
**FIG. 8** illustrates the displacement of the vibration isolation system as claimed in the present disclosure operating in vertical (Y-axis) direction loading to mitigate the transmission of vibration, in accordance with one example of the present disclosure.

In the appended figures, similar components and/or features may have the same numerical reference label. Further, various components of the same type may be distinguished by following the reference label with a letter. If only the first numerical reference label is used in the specification, the description is applicable to any one of the similar components and/or features having the same first numerical reference label irrespective of the suffix.

### DESCRIPTION OF THE INVENTION

The present disclosure relates to vibration isolation systems. More specifically, the present disclosure concerns a vibration isolation mechanism designed to mitigate the effects of seismic and other vibrational forces on mounted structures.

Examples are provided so as to thoroughly and fully convey the scope of the present disclosure to the person skilled in the art. Numerous details are set forth, relating to specific components, and methods, to provide a complete understanding of examples of the present disclosure. It will be apparent to the person skilled in the art that the details provided in the examples should not be construed to limit the scope of the present disclosure. In some examples, well-known processes, well-known apparatus structures, and well-known techniques are not described in detail.

The terminology used, in the present disclosure, is only for the purpose of explaining a particular example and such terminology shall not be considered to limit the scope of the present disclosure. As used in the present disclosure, the forms "a," "an," and "the" may be intended to include the plural forms as well, unless the context clearly suggests otherwise. The terms "comprises," "comprising," "including," and "having," are open ended transitional phrases and therefore specify the presence of stated features, elements, modules, units and/or components, but do not forbid the presence or addition of one or more other features, elements, components, and/or groups thereof.

The term 'plinth' herein refers to a structural base or platform used to support and stabilize an object or equipment, such as a cabinet or enclosure. The plinth is typically positioned on the floor and serves to elevate the equipment, providing stability and creating space for cables, wiring, or other components beneath the equipment.

In industrial and commercial settings, the stability and resilience of mounted equipment, such as cabinets and enclosures, are essential for safety and performance, particularly in regions where seismic activity is a concern. Equipment mounted in such areas is vulnerable to seismic forces, which can cause substantial displacement and potentially lead to structural failure or malfunctions. To address these risks, cabinets and other structures are commonly mounted on a plinth a structural base that serves as both a stabilizing platform and a means of elevating the equipment, providing space for cables, wiring, or ventilation.

Traditional plinth designs often rely on rigid connections and reinforced materials to withstand seismic forces. Traditional designs can provide stability to a certain degree but typically require substantial material use to meet seismic performance standards, which drives up production costs. Furthermore, these designs do not fully isolate the cabinet from seismic vibrations and movements. When seismic forces act on the ground, they may still cause a degree of displacement that is transferred up through the plinth and into the cabinet. This displacement can impact sensitive components within the cabinet and potentially lead to equipment damage, especially during high-intensity seismic events.

Seismic forces are complex in nature and typically involve multidirectional movements, including side-to-side (X-axis), front-to-back (Z-axis), and vertical (Y-axis) shifts. Consequently, there exists a need for a vibration isolation system that can alleviate the aforementioned drawbacks without compromising stability.

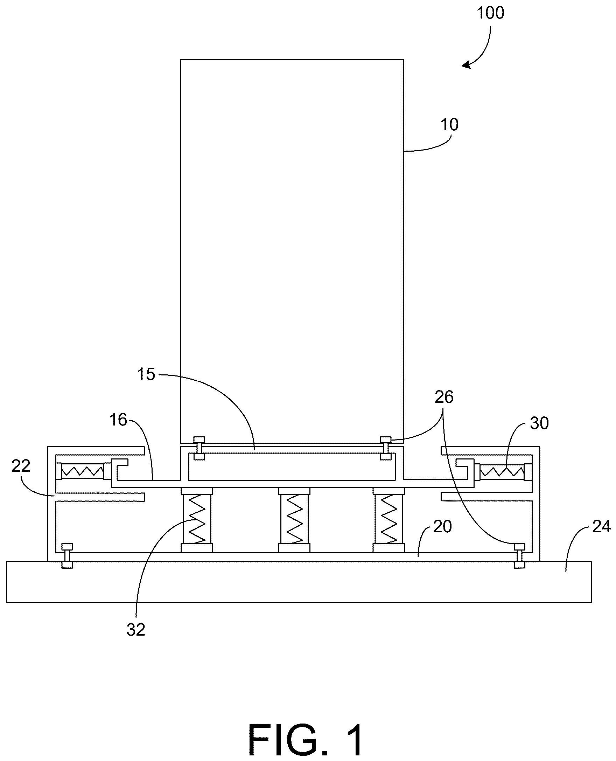

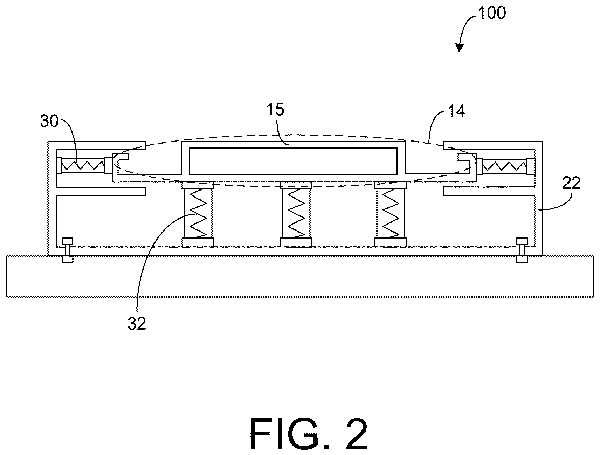

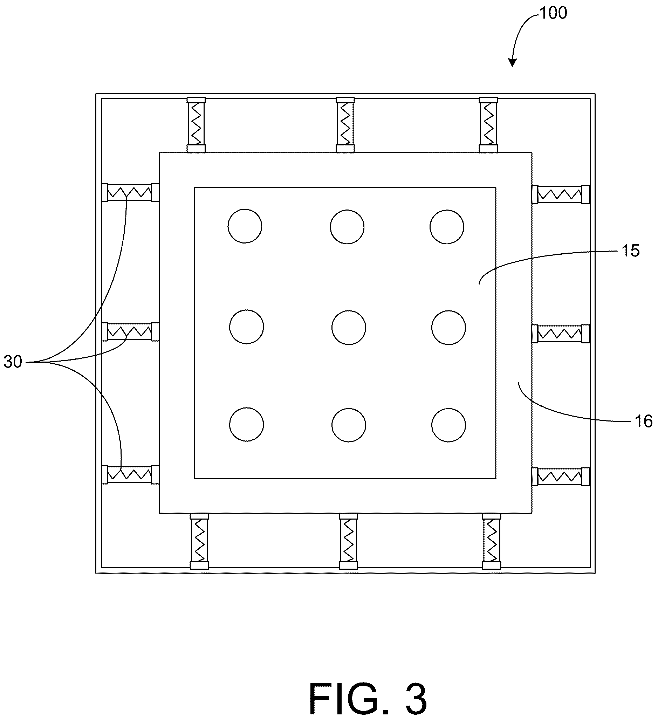

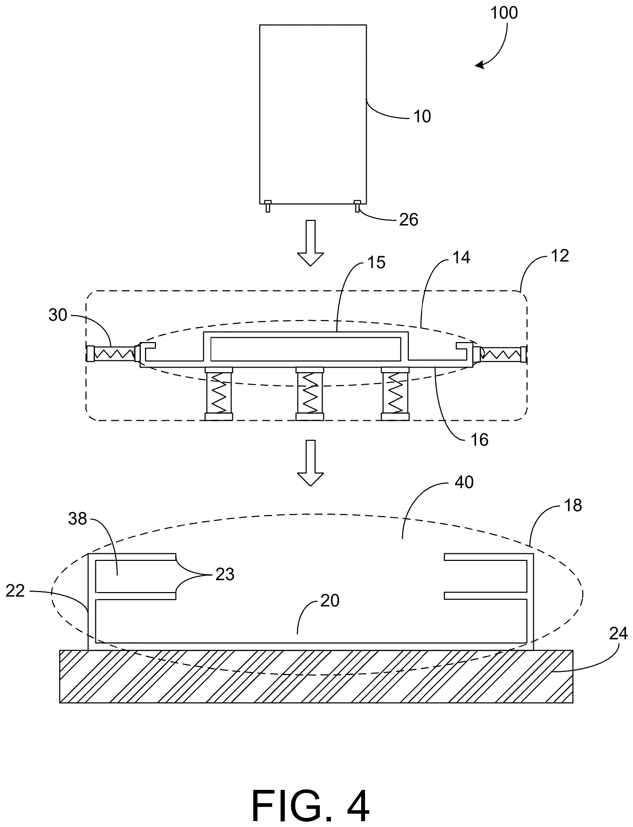

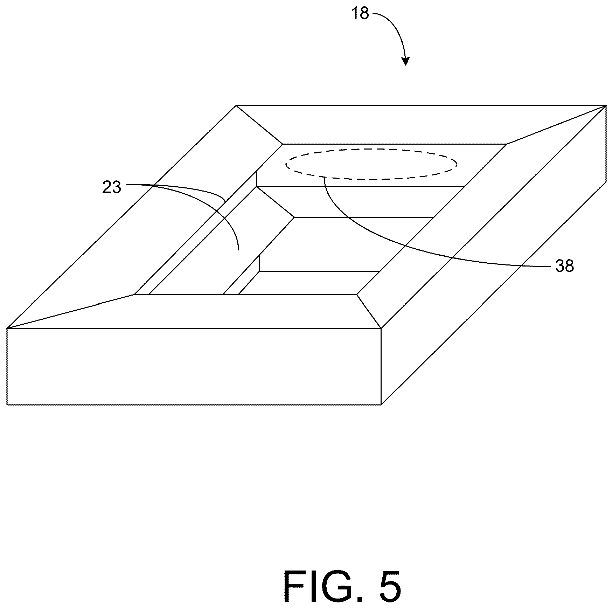

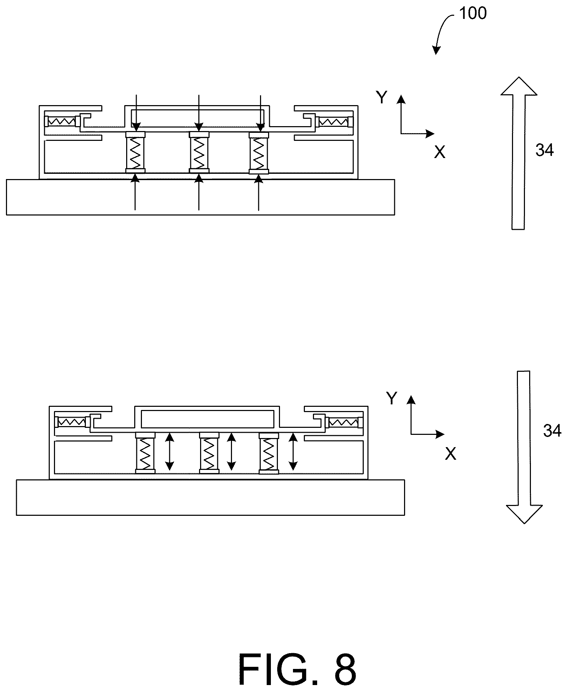

Examples, of the present disclosure will now be described with reference to the **Fig. 1** through **Fig. 8****.**

The present disclosure addresses these challenges by introducing a vibration isolation system (100). The vibration isolation system (100) may be configured to mitigate the transmission of vibrations to equipment and machinery enclosed within a cabinet (10). The vibration isolation system (100) may utilize a dual-frame structure, comprising a top frame (12), which may serve as the mounting platform for the cabinet (10), and a bottom frame (18), which may be securely mounted to a floor or another rigid surface (24).

In an example, the top frame (12) may be movably mounted on an operative surface of the bottom frame (18), allowing controlled movement in response to external forces.

The bottom frame (18) may be defined by a box-shaped structure, which may include a bottom surface (20), vertically extending side surfaces (22), and a pair of flanges (23). The pair of flanges (23) may partially extend orthogonally from the side surfaces (22) to form a C-shaped pocket (38) and an opening (40). The bottom surface (20) may be configured to be affixed to the rigid surface (24) through cementing or a series of fasteners (26).

The fasteners (26) may be configured to withstand oscillating forces and prevent any displacement of the bottom frame relative to the ground or mounting surface.

The bottom frame (18) may be constructed in various box configurations, such as a square box, or a rectangular box structure, depending on application needs.

Within the system (100), the top frame (12) may incorporate a plinth (14), a plurality of primary resilient members (30), and secondary resilient members (32), each of which may serve specialized damping functions. The plinth (14) may be structured with a mounting base (15) and a ledge (16) that may extend parallel to the edges of the mounting base (15) in an outward direction. The ledge (16) may surround the mounting base (15), with one end of each primary resilient member (30) secured to an operative surface of the ledge (14), while an operative bottom surface of the mounting base (15) may secure one end of each secondary resilient member (32).

To enhance stability, the ledge (16) may surround the mounting base (15) on all operative sides, allowing each side of the ledge (16) to accommodate at least two, primary resilient members (30). Thus, the mounting base (15) may hold a total of at least eight primary resilient members (30). Additionally, the bottom surface of the mounting base (15) may be fitted with at least four secondary resilient members (32), depending on vibration control requirements.

The bottom surface of the mounting base (15) may be fitted with at least four secondary resilient members. Shape of the mounting base (15) may be complementary to the opening (40) configured on the bottom frame to ensure a snug fit.

Further, in an operative configuration of the proposed system (100), the top frame (12) may be positioned within the bottom frame (18) so that the ledge (16) resides within the C-shaped pocket (38), with the opposite ends of the primary resilient members (30) abutting the inner surfaces of the side surfaces within the pocket (38). The other ends of the secondary resilient members (32) may compressibly rest against the bottom surface (20) of the bottom frame (18). This setup may enable the cabinet (10) to be securely mounted on the top surface (12) of the mounting base (15) with additional fasteners (26).

Together, the primary resilient members (30) may restrict lateral movement of the top frame (30), while the secondary resilient members (32) may limit upward and downward motion. The coordinated action between the primary and secondary resilient members (30, 32) may absorb undesirable vibrations without transferring them to the sensitive equipment within the cabinet (10).

In an example, the recess of the C-shaped pocket (38) and the vertical displacement space within the isolation system (100) may provide sufficient clearance for the lateral displacement of the top frame (12), thereby preventing metal-to-metal contact. In addition, the primary resilient members (30) and secondary resilient members (32) may be optimized to dampen both horizontal and vertical vibrations, respectively.

Stiffness of the primary resilient members (30) may be identical as that of the secondary resilient members (32). The stiffness of the primary resilient members (30) may be different from that of the secondary resilient members (32). The stiffness of the primary resilient members (30) and the secondary resilient members (32) may be dependent on the intensity of horizontal and vertical vibrational waves as well as the gross weight of the cabinet (10).

The configuration may also incorporate a tolerance allowance between the ledges (16) of the plinth (14) and the side surfaces of the bottom frame (18). This configuration may allow the primary resilient members (30) to facilitate a degree of horizontal motion for the plinth (14) relative to the bottom frame (18), while the secondary resilient members (32) may control vertical motion within a defined range, preventing excessive movement. The tolerance provided may enable the top frame (12) to have relative motion without compromising the stability of the cabinet (10) housed above.

Advantageously, the proposed configuration of the vibration isolation system (100) actively decouples the cabinet (10) from ground-transmitted vibrations through a multi-directional damping configuration, and thus addresses both vertical and horizontal oscillations. This capability may ensure that the system (100) remains stable across multiple axes. A defined ground motion (34) may signify the direction of oscillation, while a neutral state (36) may indicate the system's balanced position.

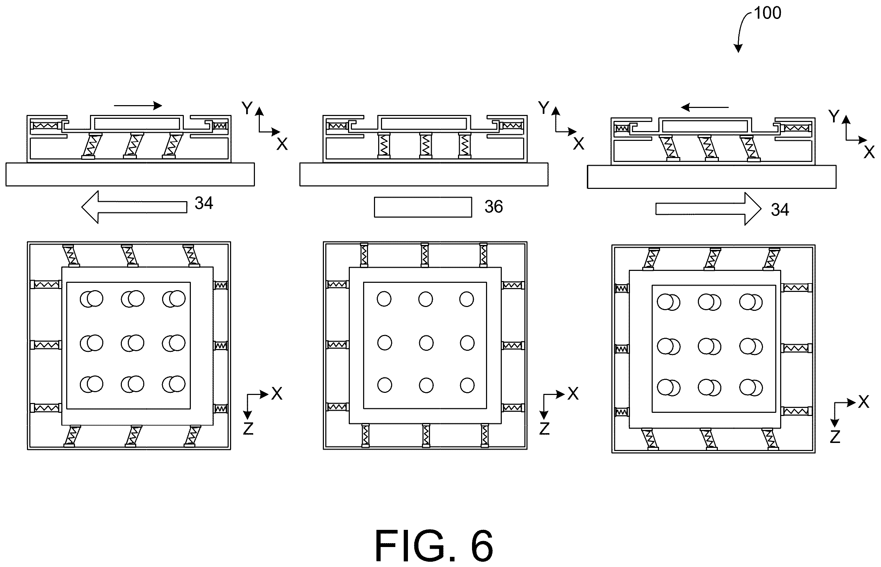

When vibrational forces impact the rigid surface (24), these forces propagate upward toward the bottom frame (18), which is securely mounted to the rigid surface (24) via fasteners (26). Upon reaching the bottom surface (20) of the bottom frame, the vibrational forces encounter the secondary resilient members (32) attached to the bottom surface (20). As depicted in Fig. 6, the secondary resilient members (32) are configured to counteract vertical vibrations by compressing and expanding in response to upward or downward movements. These secondary resilient members (32) absorb the vertical component of the vibrational energy, dissipating it through compression and expansion, thereby preventing the direct transmission of force to the plinth (14) and the cabinet (10) positioned above.

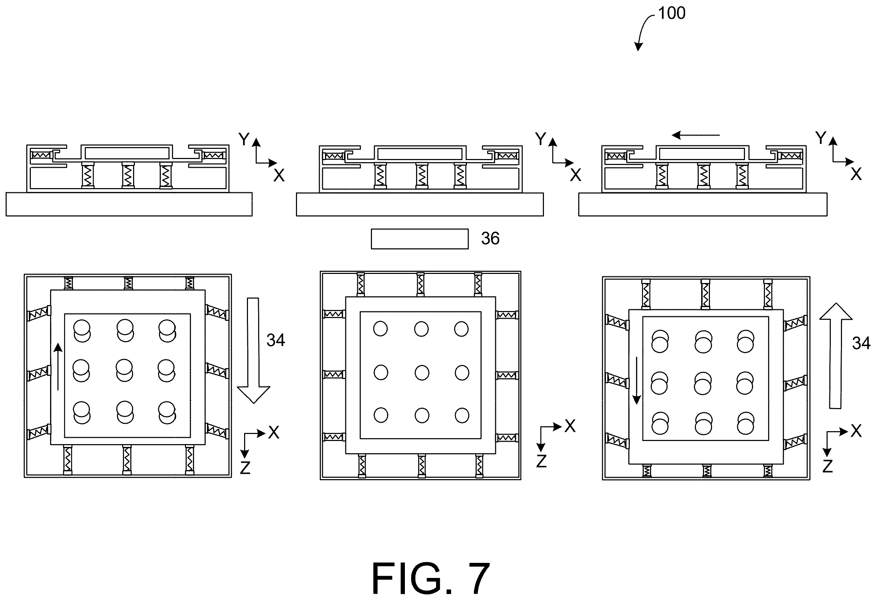

Simultaneously, the primary resilient members (30) are positioned along the inner lateral surfaces of the side walls of the top frame (12). As shown in **Figs. 6** and **7****,** the primary resilient members (30) are strategically located to address horizontal vibrations. When a lateral force arises, whether due to seismic activity or industrial machinery vibrations, the primary resilient members (30) absorb the energy by flexing horizontally. This lateral damping mechanism effectively stops vibrational energy from reaching the cabinet (10), further stabilizing the system (100). Specifically, **Fig.** 6 illustrates vibration damping along the X-axis (side-to-side), while Fig. 7 shows vibration damping along the Z-axis (front-to-back).

As the resilient members (30, 32) absorb the vibrational energy, the plinth (14), which is mounted on the primary and secondary resilient members (30, 32), remains relatively stationary. The plinth (14) is configured to "float" on the resilient members (30, 32), allowing it to displace slightly within a controlled range in response to incoming forces without compromising the stability of the cabinet (10). The laterally extending ledges (16) of the plinth (14), connected to the primary resilient members (30), facilitate limited horizontal movement, while the secondary resilient members (32) below permit controlled vertical motion. This multi-axis flexibility of the plinth (14) is essential for isolating the cabinet (10) from both vertical shocks and lateral shifts.

In practical operation, when both vertical and horizontal forces act simultaneously, the primary and secondary resilient members (30, 32) work in tandem. For instance, if an upward shock is accompanied by a sideways shift, the secondary resilient members (32) compress to absorb the vertical impact, while the primary resilient members (30) flex to counter the horizontal motion. The combination of these responses may ensure that the cabinet (10) above the plinth (14) remains as unaffected as possible by external disturbances.

The vibration isolation system (100) can be particularly effective in environments prone to sustained or high-impact vibrations. The passive configuration of the resilient members (30, 32) can allow the system (100) to react instantaneously to any force, without the need for external controls or adjustments. Furthermore, the damping properties of the resilient members (30, 32) can prevent resonant vibrations from developing, which could otherwise amplify and worsen the vibration impact on the cabinet (10). In scenarios where repeated or sustained vibrational loads occur, the resilient members (30, 32) undergo controlled compression and relaxation cycles. This elasticity allows the resilient members (30, 32) to return to their original positions once the vibrational forces subside, ready to respond to the next instance of vibration. Over time, this adaptive mechanism maintains the system's effectiveness without excessive wear, which can provide long-term protection for the cabinet (10).

The foregoing description of the examples has been provided for purposes of illustration and not intended to limit the scope of the present disclosure. Individual components of a particular example are generally not limited to that particular example, but, are interchangeable. Such variations are not to be regarded as a departure from the present disclosure, and all such modifications are considered to be within the scope of the present disclosure.

The present disclosure described hereinabove has several technical advantages including, but not limited to, the vibration isolation system that:
- can effectively absorbs and dissipates vibrations generated by seismic events, construction, or demolition activities by minimizing direct vibration transfer to the cabinet, and thus reducing the risks to both the equipment and electrical connections within;
- can ensure stability under high-vibration conditions;
- can minimize unnecessary material costs while maintaining the durability and strength needed for high-performance applications;
- can allow equipment within the cabinet to remain connected and secure despite external vibrations; and
- can allow quick adjustments or repairs, to reduce the downtime and improve the serviceability.

The foregoing disclosure has been described with reference to the accompanying examples which do not limit the scope and ambit of the disclosure. The description provided is purely by way of example and illustration.

The examples herein and the various features and advantageous details thereof are explained with reference to the nonlimiting examples in the following description. Descriptions of well-known components and processing techniques are omitted so as to not unnecessarily obscure the examples herein. The examples used herein are intended merely to facilitate an understanding of ways in which the examples herein may be practiced and to further enable those of skill in the art to practice the examples herein. Accordingly, the examples should not be construed as limiting the scope of the examples herein.

The foregoing description of the specific examples so fully reveal the general nature of the examples herein that others can, by applying current knowledge, readily modify and/or adapt for various applications such specific examples without departing from the generic concept, and, therefore, such adaptations and modifications should and are intended to be comprehended within the meaning and range of equivalents of the disclosed examples. It is to be understood that the phraseology or terminology employed herein is for the purpose of description and not of limitation.

Any discussion of devices, articles or the like that has been included in this specification is solely for the purpose of providing a context for the disclosure. It is not to be taken as an admission that any or all of these matters form a part of the prior art base or were common general knowledge in the field relevant to the disclosure as it existed anywhere before the priority date of this application.

While considerable emphasis has been placed herein on the components and component parts of the preferred examples, it will be appreciated that many examples can be made and that many changes can be made in the preferred examples without departing from the principles of the disclosure. These and other changes in the preferred example as well as other examples of the disclosure will be apparent to those skilled in the art from the disclosure herein, whereby it is to be distinctly understood that the foregoing descriptive matter is to be interpreted merely as illustrative of the disclosure and not as a limitation.

Described herein are also the following clauses:
1. A vibration isolation system (100) for isolating vibrations from transmitting to a cabinet (10), said system (100) comprising: a bottom frame (18) configured to be mounted on a rigid surface (24), said bottom frame (18) having a bottom surface (20) and side surfaces (22) extending vertically therefrom; a top frame (12) configured to support the cabinet (10), said top frame (12) comprising a mounting base (15) and ledges (16) extending outwardly from the mounting base (15), wherein said top frame (12) is movably mounted on the bottom frame (18); a plurality of primary resilient members (30) positioned between the ledges (16) of said top frame (12) and said side surfaces (22) of the bottom frame (18), said primary resilient members (30) configured to restrict lateral movement of said top frame (12) within said bottom frame (18); and a plurality of secondary resilient members (32) positioned between an operating surface of said mounting base (15) of said top frame (12) and said bottom surface (20) of said bottom frame (18), said secondary resilient members (32) configured to restrict vertical movement of said top frame (12) relative to said bottom frame (18), wherein said primary resilient members (30) and said secondary resilient members (32) are collectively configured to absorb vibrational forces in both lateral and vertical directions, thereby isolating the cabinet (10) from external vibrations transmitted through said bottom frame (18).
2. The system (100) of clause 1, wherein said bottom frame (18) is a box-shaped structure comprising a C-shaped pocket (38) and an opening (40), said opening (40) being configured to receive said top frame (12) such that said ledges (16) of said top frame (12) are positioned within said pocket (38).
3. The system (100) of clause 1, wherein said primary resilient members (30) are arranged in a spaced manner along the inner surfaces of said side surfaces (22) of said bottom frame (18), each of said primary resilient members (30) having one end coupled to said ledges (16) and an opposite end abutting the inner surface of said side surfaces (22) of said bottom frame (18).
4. The system (100) of clause 1, wherein said secondary resilient members (32) are arranged in a grid pattern on said bottom surface (20) of said bottom frame (18), each of said secondary resilient members (30) having one end coupled to the operative surface of said mounting base (15) of said top frame (12) and an opposite end abutting the bottom surface (20) of said bottom frame (18).
5. The system (100) of clause **1,** wherein said bottom frame (18) includes a plurality of fasteners (26) configured to secure said bottom frame (18) to the rigid surface (24), wherein said fasteners (26) are capable of withstanding oscillating forces acting on said bottom frame (18).
6. The system (100) of clause 1, wherein each of said primary resilient members (30) and each of said secondary resilient members (32) has stiffness level, configured to collectively absorb vibrations in multi-directional axes without compromising the stability of said top frame (12) and the cabinet (10).
7. The system (100) of clause 1, wherein said top frame (12) is dimensioned to allow lateral displacement within a predefined tolerance range inside the bottom frame (18), to provide controlled flexibility to absorb lateral and vertical vibrations.
8. A method for isolating vibrations from transmitting to a cabinet (10) mounted on a vibration isolation system (100), said method comprising the following steps: providing a bottom frame (18) and mounting said bottom frame (18) on a rigid surface (24), said bottom frame (18) having a bottom surface (20) and side surfaces (22) extending vertically therefrom; positioning a top frame (12) within said bottom frame (18), said top frame (12) comprising a mounting base (15) and ledges (16) extending outwardly from the mounting base (15); mounting a plurality of primary resilient members (30) between said ledges (16) of said top frame (12) and said side surfaces (22) of said bottom frame (18), wherein said primary resilient members (30) restricts lateral movement of said top frame (12) relative to said bottom frame (18); mounting a plurality of secondary resilient members (32) between said mounting base (15) of said top frame (12) and said bottom surface (20) of said bottom frame (18), wherein said secondary resilient members (32) restricts vertical movement of the top frame (12) relative to the bottom frame (18); securing the cabinet (10) on said mounting base (15) of said top frame (12); and absorbing vibrations through said primary resilient members (30) and said secondary resilient members (32), wherein said primary resilient members (30) absorb lateral vibrations and said secondary resilient members (32) absorb vertical vibrations, thereby isolating the cabinet (10) from external vibrations.
9. The method of clause 8, includes securing said bottom frame (12) to the rigid surface (24) using a plurality of fasteners (26) capable of withstanding oscillating forces.
10. The method of clause 8, wherein providing the bottom frame (18) includes forming said bottom frame (12) as a box-shaped structure with a C-shaped pocket (38) to receive said top frame (12), and wherein positioning said top frame (12) within said bottom frame (18) includes inserting the ledges (16) of said top frame (12) within said C-shaped pocket (38).
11. The method of clause 8, wherein mounting said primary resilient members (30) includes arranging said primary resilient members (30) in a spaced manner along the inner surfaces of said side surfaces (22) of said bottom frame (18), each of said primary resilient member having one end coupled to said ledges (16) and an opposite end abutting said side surfaces (22) of said bottom frame (18).
12. The method of clause 8, wherein mounting said secondary resilient members (32) includes arranging said secondary resilient members (32) in a grid pattern on said bottom surface (20) of said bottom frame (18), each of said secondary resilient members (32) having one end coupled to said mounting base (15) of said top frame (12) and an opposite end abutting said bottom surface (20) of said bottom frame (18).
13. The method of clause 8, includes providing a tolerance between said ledges (16) and said side surfaces (22) of said bottom frame (18).
14. The method of clause 8, includes selecting the stiffness levels of said primary resilient members (30) and said secondary resilient members (32), enabling said resilient members to dampen multi-directional vibrations.

## Claims

1. A vibration isolation system (100) for isolating vibrations from transmitting to a cabinet (10), said system (100) comprising:
a bottom frame (18) configured to be mounted on a rigid surface (24), said bottom frame (18) having a bottom surface (20) and side surfaces (22) extending vertically therefrom;
a top frame (12) configured to support the cabinet (10), said top frame (12) comprising a mounting base (15) and ledges (16) extending outwardly from the mounting base (15), wherein said top frame (12) is movably mounted on the bottom frame (18);
a plurality of primary resilient members (30) positioned between the ledges (16) of said top frame (12) and said side surfaces (22) of the bottom frame (18), said primary resilient members (30) configured to restrict lateral movement of said top frame (12) within said bottom frame (18); and
a plurality of secondary resilient members (32) positioned between an operating surface of said mounting base (15) of said top frame (12) and said bottom surface (20) of said bottom frame (18), said secondary resilient members (32) configured to restrict vertical movement of said top frame (12) relative to said bottom frame (18),
wherein said primary resilient members (30) and said secondary resilient members (32) are collectively configured to absorb vibrational forces in both lateral and vertical directions, thereby isolating the cabinet (10) from external vibrations transmitted through said bottom frame (18).

2. The system (100) as claimed in claim 1, wherein said bottom frame (18) is a box-shaped structure comprising a C-shaped pocket (38) and an opening (40), said opening (40) being configured to receive said top frame (12) such that said ledges (16) of said top frame (12) are positioned within said pocket (38).

3. The system (100) of any preceding claim, wherein said primary resilient members (30) are arranged in a spaced manner along the inner surfaces of said side surfaces (22) of said bottom frame (18), each of said primary resilient members (30) having one end coupled to said ledges (16) and an opposite end abutting the inner surface of said side surfaces (22) of said bottom frame (18).

4. The system (100) of any preceding claim, wherein said secondary resilient members (32) are arranged in a grid pattern on said bottom surface (20) of said bottom frame (18), each of said secondary resilient members (30) having one end coupled to the operative surface of said mounting base (15) of said top frame (12) and an opposite end abutting the bottom surface (20) of said bottom frame (18).

5. The system (100) of any preceding claim, wherein said bottom frame (18) includes a plurality of fasteners (26) configured to secure said bottom frame (18) to the rigid surface (24), wherein said fasteners (26) are capable of withstanding oscillating forces acting on said bottom frame (18).

6. The system (100) of any preceding claim, wherein each of said primary resilient members (30) and each of said secondary resilient members (32) has stiffness level, configured to collectively absorb vibrations in multi-directional axes without compromising the stability of said top frame (12) and the cabinet (10).

7. The system (100) of any preceding claim, wherein said top frame (12) is dimensioned to allow lateral displacement within a predefined tolerance range inside the bottom frame (18), to provide controlled flexibility to absorb lateral and vertical vibrations.

8. A method for isolating vibrations from transmitting to a cabinet (10) mounted on a vibration isolation system (100), said method comprising the following steps:
providing a bottom frame (18) and mounting said bottom frame (18) on a rigid surface (24), said bottom frame (18) having a bottom surface (20) and side surfaces (22) extending vertically therefrom;
positioning a top frame (12) within said bottom frame (18), said top frame (12) comprising a mounting base (15) and ledges (16) extending outwardly from the mounting base (15);
mounting a plurality of primary resilient members (30) between said ledges (16) of said top frame (12) and said side surfaces (22) of said bottom frame (18), wherein said primary resilient members (30) restricts lateral movement of said top frame (12) relative to said bottom frame (18);
mounting a plurality of secondary resilient members (32) between said mounting base (15) of said top frame (12) and said bottom surface (20) of said bottom frame (18), wherein said secondary resilient members (32) restricts vertical movement of the top frame (12) relative to the bottom frame (18);
securing the cabinet (10) on said mounting base (15) of said top frame (12); and
absorbing vibrations through said primary resilient members (30) and said secondary resilient members (32), wherein said primary resilient members (30) absorb lateral vibrations and said secondary resilient members (32) absorb vertical vibrations, thereby isolating the cabinet (10) from external vibrations.

9. The method as claimed in claim 8, comprising: securing said bottom frame (12) to the rigid surface (24) using a plurality of fasteners (26) capable of withstanding oscillating forces.

10. The method of any one of claims 8 to 9, wherein providing the bottom frame (18) includes forming said bottom frame (12) as a box-shaped structure with a C-shaped pocket (38) to receive said top frame (12), and wherein positioning said top frame (12) within said bottom frame (18) includes inserting the ledges (16) of said top frame (12) within said C-shaped pocket (38).

11. The method of any one of claims 8 to 10, wherein mounting said primary resilient members (30) includes arranging said primary resilient members (30) in a spaced manner along the inner surfaces of said side surfaces (22) of said bottom frame (18), each of said primary resilient member having one end coupled to said ledges (16) and an opposite end abutting said side surfaces (22) of said bottom frame (18).

12. The method of any one of claims 8 to 11, wherein mounting said secondary resilient members (32) includes arranging said secondary resilient members (32) in a grid pattern on said bottom surface (20) of said bottom frame (18), each of said secondary resilient members (32) having one end coupled to said mounting base (15) of said top frame (12) and an opposite end abutting said bottom surface (20) of said bottom frame (18).

13. The method of any one of claims 8 to 12, includes providing a tolerance between said ledges (16) and said side surfaces (22) of said bottom frame (18).

14. The method of any one of claims 8 to 13, includes selecting the stiffness levels of said primary resilient members (30) and said secondary resilient members (32), enabling said resilient members to dampen multi-directional vibrations.
